# FASCICULE DE BREVET EUROPEEN

(11) **EP 4 078 066 B1**
(45) Date de publication et mention de la délivrance du brevet: **28.01.2026**
(21) Numéro de dépôt: 20842260.0
(22) Date de dépôt: 07.12.2020
(51) Int. Cl.: F28F 9/26, H01M 10/6555, F28F 9/00

(54) **DISPOSITIF DE RÉGULATION THERMIQUE ET PROCÉDÉ D'ASSEMBLAGE CORRESPONDANT**
VORRICHTUNG ZUR THERMISCHEN REGULIERUNG UND ENTSPRECHENDES MONTAGEVERFAHREN
THERMAL REGULATION DEVICE AND CORRESPONDING ASSEMBLY METHOD

(30) Priorité: 20.12.2019 FR 1915330
(43) Date de publication de la demande: 26.10.2022
(73) Titulaire: VALEO SYSTEMES THERMIQUES, 78320 Le Mesnil Saint-Denis (FR)
(72) Inventeur: BARRE, Boris, 72210 La Suze Sur Sarthe (FR); MIZRAHI, Anne-Sophie, 72210 La Suze Sur Sarthe (FR); MULLER, Jean Damien, 72210 La Suze Sur Sarthe (FR); PREVOST, Jean Christophe, 72270 La Suze Sur Sarthe (FR); TISON, Frédéric, 72210 La Suze Sur Sarthe (FR)
(74) Mandataire: Valeo Powertrain Systems
(86) Numéro de dépôt international: PCT/FR2020/052307
(87) Numéro de publication internationale: WO 2021/123550

(56) Documents cités:
- EP-A2- 1 271 085
- WO-A1-2012/120092
- WO-A1-2013/037742
- WO-A2-2014/132047

## Description

La présente invention concerne un dispositif de régulation thermique de composants électriques et/ou électroniques susceptibles de dégager de la chaleur lors de leur fonctionnement, ces composants étant notamment des éléments de stockage d'énergie électrique ou un dispositif d'électronique de puissance, notamment dans le domaine automobile. L'invention concerne également un procédé d'assemblage d'un tel dispositif de régulation thermique. De manière plus spécifique, la présente invention se rapporte à un dispositif de régulation thermique de composants électriques et/ou électroniques tel que défini par le préambule de la revendication 1, et tel que divulgué en figure 4 du document WO2014/132047A2.

L'invention trouve une application avantageuse dans le domaine des dispositifs de régulation thermique d'un dispositif ou module d'électronique de puissance, c'est-à-dire comportant des composants électroniques de puissance, par exemple de façon non limitative des semi-conducteurs, tels que des diodes ou transistors. En fonctionnement la température d'un tel dispositif ou module d'électronique de puissance peut s'élever ce qui risque d'endommager certains des composants électroniques de puissance.

L'invention trouve également une application avantageuse dans le domaine des dispositifs de régulation thermique d'éléments de stockage d'énergie électrique, tels que des batteries de véhicules automobiles à motorisation électrique et/ou hybride. L'énergie électrique des véhicules à motorisation électrique et/ou hybride est fournie par une ou plusieurs batteries. Durant leur fonctionnement, les éléments de stockage d'énergie électrique tels que les batteries, sont amenés à chauffer et risquent ainsi de s'endommager.

Une technique de charge, dite de charge rapide, consiste à charger les éléments de stockage d'énergie sous une tension et un ampérage élevés, en un temps réduit, notamment en un temps maximum d'une vingtaine de minutes. Cette charge rapide implique un échauffement important des éléments de stockage d'énergie électrique qu'il convient de traiter.

Pour la régulation thermique, notamment le refroidissement, d'éléments de stockage d'énergie électrique, tels que des batteries, il est connu d'utiliser un dispositif de régulation thermique.

Selon une solution connue, le dispositif de régulation thermique comporte des plaques de refroidissement intégrant des canaux de circulation d'un fluide caloporteur, tel qu'un liquide de refroidissement, agencées entre les éléments de stockage d'énergie électrique.

Les plaques sont brasées entre elles et généralement également brasées à des collecteurs d'entrée et de sortie du liquide de refroidissement afin de garantir l'étanchéité. En particulier, lors de l'assemblage, de tels éléments de stockage d'énergie électrique par exemple et les paires de plaques sont empilées successivement. Cependant, un tel assemblage n'offre aucune flexibilité de montage quant à l'insertion des éléments de stockage d'énergie à refroidir dans le dispositif de régulation thermique.

Une autre problématique est d'assurer un débit adéquat du fluide caloporteur dans chaque paire de plaques, notamment au niveau des paires intermédiaires qui sont agencées entre deux faces de composants à réguler thermiquement, et les paires en extrémité qui ne sont agencée que contre une face d'un composant à réguler thermiquement.

L'invention a pour objectif de pallier au moins partiellement ces problèmes de l'art antérieur en permettant une meilleure insertion dans le dispositif de régulation thermique des composants électriques et/ou électroniques, tels que des éléments de stockage d'énergie à refroidir, tout en assurant un refroidissement efficace des composants électriques et/ou électroniques susceptibles de dégager de la chaleur lors de leur fonctionnement.

Un autre objectif est d'optimiser le débit de fluide caloporteur entre les paires de plaques.

À cet effet, l'invention a pour objet un dispositif de régulation thermique d'au moins un composant électronique et/ou électrique tel que défini par la revendication 1.

Selon l'invention, ledit au moins un collecteur de fluide caloporteur comporte au moins deux connecteurs creux complémentaires. Chaque connecteur est assemblé à une paire de plaques associée et comprend une zone de distribution présentant au moins une fente débouchant dans le canal de circulation de fluide caloporteur défini par la paire de plaques. les connecteurs assemblés à deux paires de plaques adjacentes comprennent des parties mâle et femelle complémentaires, emmanchées l'une dans l'autre, la partie mâle portant au moins un joint d'étanchéité.

Les connecteurs assemblés chacun à une paire de plaques associée, peuvent être assemblés mécaniquement entre eux en étant emmanchés l'un dans l'autre, ce qui offre une souplesse de montage lors de l'insertion des composants entre les paires de plaques. De plus, cela évite l'endommagement des zones de connexion fluidique des plaques.

Le dispositif de régulation thermique peut en outre comporter une ou plusieurs caractéristiques suivantes décrites ci-après, prises séparément ou en combinaison.

L'empilement d'au moins deux paires de plaques comporte deux plaques d'extrémité.

Ledit au moins un joint d'étanchéité est par exemple réalisé en élastomère.

La fonction d'étanchéité n'est pas destinée à être assurée par brasage. La fonction d'étanchéité est assurée par le ou les joints d'étanchéité rapportés et assemblés au dispositif. La liaison mécanique entre les connecteurs n'est pas irréversible. Ledit au moins un joint d'étanchéité n'est pas destiné à fondre pour assurer l'étanchéité.

Les connecteurs sont par exemple de forme générale tubulaire ou cylindrique.

Selon un aspect, ledit au moins un collecteur de fluide caloporteur comporte un nombre prédéfini de connecteurs creux complémentaires, dont deux connecteurs d'extrémité.

Ledit au moins un collecteur de fluide caloporteur peut comporter au moins un connecteur intermédiaire entre les deux connecteurs d'extrémité.

Les connecteurs d'extrémité comportent un premier connecteur d'extrémité comprenant une partie mâle et un deuxième connecteur d'extrémité comprenant une partie femelle.

L'un des connecteurs d'extrémité est configuré pour être raccordé à un circuit du fluide caloporteur.

L'autre connecteur d'extrémité est obturé d'un côté opposé à l'empilement de plaques.

Selon un mode de réalisation préféré, l'un des connecteurs d'extrémité présente une connectique de raccordement au circuit du fluide caloporteur.

L'autre connecteur d'extrémité peut présenter une paroi borgne obturant une ouverture d'une plaque d'extrémité.

La connectique de raccordement peut présenter une forme générale cylindrique s'étendant depuis une plaque d'extrémité à l'opposé de l'empilement de plaques.

Selon un mode de réalisation particulier, ledit dispositif comporte deux collecteurs pour l'entrée et pour la sortie du fluide caloporteur. Chaque collecteur comporte au moins deux connecteurs d'extrémité tels que définis précédemment.

Selon un autre aspect, ledit dispositif comporte au moins une paire de plaques intermédiaires entre deux plaques d'extrémité.

La paire de plaques intermédiaires est assemblée avec un connecteur intermédiaire comportant d'un côté une partie mâle et de l'autre côté une partie femelle.

De façon avantageuse, les parties mâles des connecteurs sont identiques.

De même, les parties femelles des connecteurs sont identiques.

Selon un exemple de réalisation, les parties mâles des connecteurs présentent au moins une rainure au niveau de laquelle ledit au moins un joint d'étanchéité est disposé.

Selon encore un autre aspect, les plaques sont agencées selon un axe d'empilement) et les parties mâle et femelle complémentaires des connecteurs sont emmanchées l'une dans l'autre selon l'axe d'empilement.

De préférence, les connecteurs sont emmanchés avec un jeu axial entre la fin de la partie femelle et l'extrémité de la partie mâle.

Les connecteurs peuvent coulisser l'un dans l'autre lors de l'interposition d'un composant entre deux paires de plaques, de façon à permettre de comprimer les paires de plaques et le ou les composants après assemblage.

Selon un exemple de réalisation, les connecteurs présentent respectivement au moins deux fentes) débouchant dans le canal de circulation de fluide caloporteur défini par la paire de plaques associée.

Les deux fentes sur chaque connecteur sont configurées pour permettre une distribution du fluide avec un débit similaire permettant un refroidissement de tous les composants de la même façon.

Les deux fentes peuvent être dimensionnées de façon à présenter un ratio de la section totale de passage du fluide caloporteur à travers les deux fentes du connecteur sur la section de passage du fluide caloporteur dans le collecteur de fluide caloporteur, entre 12% et 25%, en particulier entre 16% et 21%. Ceci permet de garantir un juste équilibrage du fluide caloporteur dans les différentes plaques, suivant le nombre de plaques.

Lorsque les connecteurs sont de forme générale cylindrique, les fentes peuvent s'étendre sur une circonférence de la zone de distribution selon un angle cumulé entre 30° et 180°.

Avantageusement, la partie mâle d'un connecteur porte au moins deux joints d'étanchéité.

De façon alternative, un joint d'étanchéité à au moins deux lèvres peut être prévu sur chaque partie mâle.

Le ou les joints d'étanchéité sont de forme complémentaire à la partie mâle du connecteur, par exemple de forme torique.

Selon un autre aspect, les connecteurs présentent respectivement une collerette. Les collerettes des connecteurs permettent de faciliter l'assemblage.

La collerette peut présenter une surface de détrompage. Cela permet d'assurer le montage des connecteurs dans une position précise.

Selon un mode de réalisation, les plaques présentent chacune au moins une ouverture, et les connecteurs sont assemblés aux paires de plaques de sorte que la zone de distribution de chaque connecteur est agencée au niveau des ouvertures des plaques d'une paire associée.

Selon le mode de réalisation décrit, chaque plaque présente deux ouvertures.

Les deux ouvertures peuvent être dans une même région de connexion fluidique.

Les plaques comportent avantageusement un collet bordant au moins une, de préférence chaque ouverture.

Selon un aspect, les plaques et les connecteurs sont métalliques. Chaque paire de plaques peut être assemblée par brasage à au moins un connecteur, de préférence à deux connecteurs.

L'invention concerne aussi un procédé d'assemblage d'un dispositif de régulation thermique selon l'une des revendications, comportant les étapes suivantes :
a. assembler au moins deux paires de plaques définissant entre elles un canal de circulation de fluide caloporteur,
b. assembler au moins un premier connecteur à une première paire de plaques associée et un deuxième connecteur à une deuxième paire de plaques associée, de sorte que ladite au moins une fente de la zone de distribution de chaque connecteur débouche dans le canal de circulation de fluide caloporteur défini par la paire de plaques associée,
c. disposer au moins un joint d'étanchéité sur la partie mâle d'au moins un des connecteurs, et
d. assembler les connecteurs entre eux en emmanchant les parties mâle et femelle des connecteurs des paires de plaques adjacentes.

Un dispositif ainsi assemblé peut être livré chez un constructeur pour l'assemblage du ou des composants entre les paires de plaques.

Le ou les connecteurs sont assemblés à une paire de plaques associée par brasage.

Le procédé est dépourvu d'étape de brasage de l'ensemble dudit dispositif.

L'étape d'assemblage des connecteurs est donc une étape d'assemblage mécanique. Une telle étape d'assemblage mécanique peut être réalisée à température ambiante, contrairement à une étape d'assemblage par brasage par passage dans un four.

D'autres avantages et caractéristiques de l'invention apparaîtront plus clairement à la lecture de la description suivante donnée à titre d'exemple illustratif et non limitatif, et des dessins annexés parmi lesquels :
[Fig. 1] est une vue en perspective d'un dispositif de régulation thermique comportant un empilement de paires de plaques et deux collecteurs de fluide caloporteur.
[Fig. 2] est une vue en perspective d'une plaque du dispositif de régulation thermique de la figure 1.
[Fig. 3] montre plus en détail une zone de connexion fluidique de la plaque de la figure 2.
[Fig. 4] est une vue éclatée d'un sous-ensemble de régulation thermique comportant une paire de plaques, deux connecteurs et des joints d'étanchéité avant assemblage.
[Fig. 5] est une vue en perspective du sous-ensemble de régulation thermique de la figure 4 assemblé.
[Fig. 6] est une vue agrandie d'une extrémité de l'empilement du dispositif de régulation thermique de la figure 1.
[Fig. 7] est une vue agrandie de l'autre extrémité de l'empilement du dispositif de régulation thermique de la figure 1.
[Fig. 8] montre un mode de réalisation d'un connecteur intermédiaire d'au moins un collecteur de fluide caloporteur de la figure 1.
[Fig. 9] est une vue partiellement en coupe montrant le connecteur intermédiaire de la figure 8 assemblé au niveau des ouvertures d'une paire de plaques.
[Fig. 10] montre deux connecteurs complémentaires de deux sous-ensembles de régulation thermique assemblés l'un à l'autre.
[Fig. 11] est une vue d'un premier connecteur d'extrémité d'un collecteur de fluide caloporteur donné.
[Fig. 12] est une vue d'un deuxième connecteur d'extrémité du collecteur de fluide caloporteur donné.
[Fig. 13] est une première vue d'un premier connecteur d'extrémité d'un autre collecteur de fluide caloporteur.
[Fig. 14] est une deuxième vue du premier connecteur d'extrémité de la figure 13.
[Fig. 15] est une vue d'un deuxième connecteur d'extrémité de l'autre collecteur de fluide caloporteur.

Sur ces figures, les éléments identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

Dans la description, on peut indexer certains éléments, comme par exemple premier élément ou deuxième élément. Dans ce cas, il s'agit d'un simple indexage pour différencier et dénommer des éléments proches mais non identiques. Cette indexation n'implique pas une priorité d'un élément par rapport à un autre et on peut aisément interchanger de telles dénominations sans sortir du cadre de la présente description. Cette indexation n'implique pas non plus un ordre dans le temps.

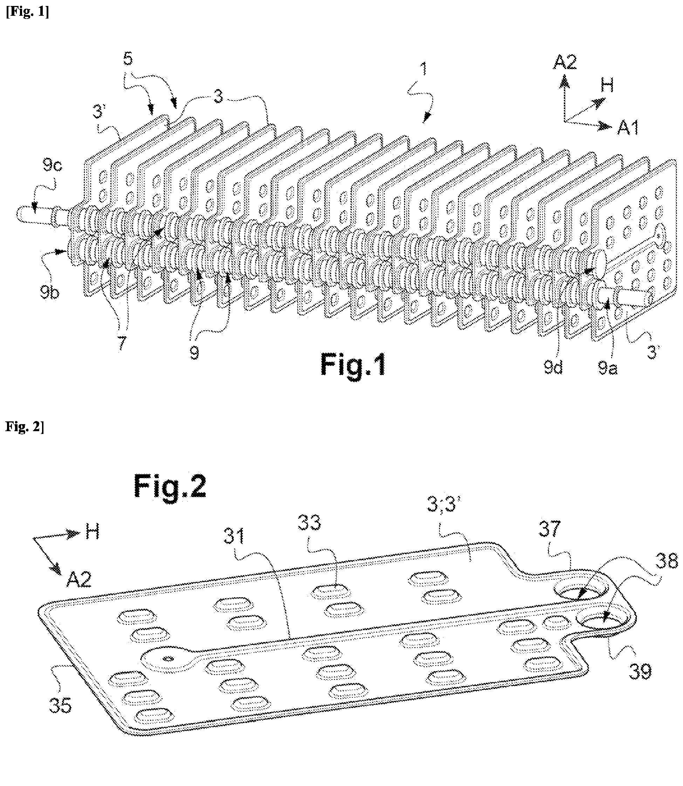

La Figure 1 représente un dispositif 1 de régulation thermique destiné à recevoir un ou plusieurs composants électroniques et/ou électriques (non représentés) susceptibles de dégager de la chaleur lors de leur fonctionnement, pour la régulation thermique de ces derniers, en particulier leur refroidissement. Les composants à réguler thermiquement, sont notamment des éléments de stockage d'énergie électrique ou un dispositif d'électronique de puissance, notamment dans le domaine automobile. À titre d'exemple, il peut s'agir de cellules électriques composant un pack batterie dans un véhicule électrique ou hybride.

Un tel dispositif 1 est notamment destiné à équiper un véhicule automobile. De façon générale, le dispositif 1 comporte un nombre prédéfini de plaques 3, 3', assemblées par paires 5. Les paires 5 de plaques 3, 3' sont disposées selon au moins une rangée selon un axe d'empilement A1. Les plaques 3, 3' comportent deux plaques d'extrémité 3' et un nombre prédéfini de plaques intermédiaires 3. Les plaques 3, définissent par paires 5, au moins un canal de circulation de fluide caloporteur. Le dispositif 1 comporte au moins deux paires 5 de plaques 3, 3'. Selon le mode de réalisation illustré sur la figure 1, l'empilement de paires 5 de plaques 3, 3' comporte une pluralité de paires 5 de plaques 3 intermédiaires entre deux paires 5 d'extrémité selon l'axe d'empilement A1.

Les composants électroniques et/ou électriques sont destinés à être interposés entre les paires 5 de plaques 3, 3', de façon à former un empilement de paires 5 de plaques 3, 3' et de composants selon l'axe d'empilement A1. Une interface thermique (non représentée) peut être prévue entre chaque composant électronique et/ou électrique et les plaques 3, 3' adjacentes de façon à garantir le transfert thermique. En variante ou en complément, au moins un isolant électrique (non représenté) peut être prévu entre les composants électroniques et/ou électriques et les plaques 3, 3' adjacentes.

Dans l'exemple illustré, le dispositif 1 présente une forme générale de parallélépipède, en particulier de parallélépipède rectangle, dont l'axe longitudinal est l'axe d'empilement A1, et s'étendant en largeur selon un axe transversal A2 à l'axe d'empilement A1, et en hauteur selon un axe H.

Le dispositif 1 comporte en outre au moins un collecteur 7 de fluide caloporteur. Le fluide caloporteur est par exemple un liquide de refroidissement. Les canaux de circulation de fluide caloporteur définis par les paires 5 de plaques 3, 3' sont agencés en communication fluidique avec ledit au moins un collecteur 7 de fluide caloporteur.

Dans l'exemple illustré, le dispositif 1 comporte deux collecteurs 7 pour l'entrée et pour la sortie du fluide caloporteur. Chaque collecteur 7 de fluide caloporteur, s'étend longitudinalement selon l'axe d'empilement A1. Au moins l'un des collecteurs 7 de fluide caloporteur est défini par une ou plusieurs pièces rapportées distinctes des plaques 3, 3'. Comme décrit plus en détail par la suite, il s'agit d'une pluralité de connecteurs creux complémentaires 9, 9a, 9b, 9c, 9d.

L'un des collecteurs 7 de fluide caloporteur permet au fluide caloporteur, en particulier froid, de circuler et d'être distribué aux différentes paires 5 de plaques 3, 3', l'autre assure le retour du fluide caloporteur, en particulier chaud, après passage de celui-ci dans les paires 5 de plaques 3. L'entrée et la sortie de fluide peuvent être disposées de deux côtés opposés du dispositif 1, de sorte que le fluide caloporteur peut s'écouler de façon générale dans le dispositif 1 selon une circulation dite en « I ». Les deux collecteurs 7 de fluide caloporteur sont reliés à un même côté de chaque plaque 3, 3'.

D'autres schémas d'écoulement peuvent être envisagés, comme une circulation dite en « U » avec l'entrée et la sortie de fluide peuvent être disposées d'un même côté du dispositif 1.

Les plaques 3, 3' sont de préférence réalisées dans un matériau métallique. Les plaques 3, 3' peuvent être réalisées à partir de tôle embouties. Préférentiellement, les plaques 3, 3', sont similaires, y compris les plaques d'extrémité 3'. De la sorte, la surface d'échange thermique avec un composant est la même quel que soit le côté de la paire 5 de plaques 3, 3' contre lequel le composant est destiné à être disposé. Selon une alternative non représentée, les plaques d'extrémité 3' peuvent être réalisées différemment.

En particulier, chaque plaque 3 s'étend suivant un plan perpendiculaire à l'axe d'empilement A1. Les plaques 3, 3' s'étendent suivant l'axe transversal A2 et l'axe H vertical. Les plaques 3, peuvent présenter une forme générale rectangulaire. De façon non limitative, les plaques 3, 3' présentent deux grands côtés s'étendant suivant l'axe H vertical et deux petits côtés s'étendant suivant l'axe transversal A2.

En outre, les plaques 3, sont conformées pour permettre, lorsqu'elles sont assemblées par paires 5, la circulation du fluide caloporteur. En particulier, les plaques 3, 3' peuvent présenter chacune une forme sensiblement creuse ou de cuvette, de façon à permettre l'écoulement du fluide caloporteur entre les deux plaques 3, 3' d'une paire 5 après assemblage.

Le fluide caloporteur peut s'écouler entre les plaques 3, 3' d'une paire 5 en une ou plusieurs passes, selon un schéma d'écoulement linéaire ou non. À cet effet, les plaques 3, peuvent présenter chacune au moins une nervure 31, qui peut être centrale comme dans l'exemple illustré de la figure 2, et dont l'extrémité peut éventuellement être arrondie. Une telle nervure 31 est prévue sur la face, dite interne, d'une plaque 3 destinée à être agencée en regard d'une plaque 3 associée à l'assemblage d'une paire de plaques 3. Les nervures 31 des deux plaques 3, sont destinées à former saillie dans le canal de circulation de fluide caloporteur afin de définir un schéma ou trajet d'écoulement ou différentes passes du fluide caloporteur.

Par ailleurs, les plaques 3, 3' peuvent présenter une multitude de bossages 33 sur leurs faces internes présentant la ou les nervures 31, afin d'assurer une tenue mécanique à la pression interne et/ou externe. Les bossages 33 sont également destinés à former saillie dans le canal de circulation de fluide caloporteur lorsque les deux plaques 3, 3' d'une paire 5 sont assemblées.

Chaque plaque 3 peut comporter un bord périphérique 35 sur tout le contour de la plaque 3. Les plaques 3, 3' sont réunies deux à deux de façon étanche au niveau de leurs bords périphériques 35 respectifs. Les plaques 3, 3' sont avantageusement réalisées dans un matériau métallique et peuvent être reliées de façon étanche par exemple par brasage.

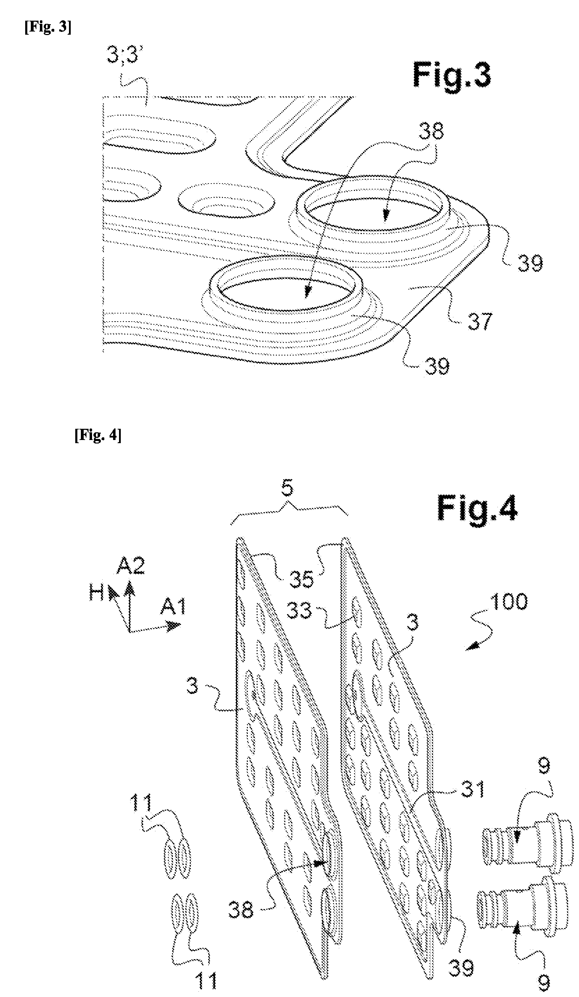

Les plaques 3, 3', comportent respectivement au moins une zone de connexion fluidique 37. Selon le mode de réalisation d'une plaque 3 ou 3' illustré sur la figure 2, une seule zone de connexion fluidique 37 est formée au niveau d'un bord latéral de la plaque 3, 3'. La plaque 3, 3' comporte une entrée et une sortie de fluide caloporteur définies par deux ouvertures 38. Dans cet exemple, les ouvertures 38 sont agencées au niveau de la même zone de connexion fluidique 37. Les ouvertures 38 sont bordées de collets 39 mieux visible sur la figure 3. Les collets 39 sont par exemple de forme générale cylindrique.

En référence aux figures 4 à 7, les collets 39 sont orientés vers l'extérieur du canal de circulation de fluide caloporteur, défini entre deux plaques 3, 3' d'une même paire 5. Les collets 39 des plaques 3 intermédiaires s'étendent en direction d'une plaque 3 d'une paire 5 voisine ou adjacente. Le ou les collets 39 d'une plaque 3' d'extrémité s'étendent selon une direction opposée à l'empilement.

Les connecteurs 9, 9a, 9b, 9c, 9d sont agencés pour mettre en communication fluidique les paires 5 de plaques 3, 3'. Les connecteurs 9, 9a, 9b, 9c, 9d comportent au moins deux connecteurs d'extrémité 9a, 9b, 9c, 9d et éventuellement un nombre prédéfini de connecteurs intermédiaires 9 assemblés de façon à définir au moins un collecteur 7 de fluide caloporteur.

Selon une configuration minimale d'un dispositif 1 avec au moins deux paires 5 de plaques 3, 3' comprenant les plaques d'extrémité 3', au moins les quatre connecteurs d'extrémité 9a, 9b, 9c, 9d sont assemblés entre eux et à ces deux paires 5. Chaque collecteur 7 de fluide caloporteur comporte deux connecteurs d'extrémité 9a, 9b, respectivement 9c, 9d.

Si au moins une paire 5 de plaques 3 intermédiaires est disposée entre les deux paires 5 extrêmes, le ou chaque collecteur 7 de fluide caloporteur comporte au moins un connecteur intermédiaire 9 outre les deux connecteurs d'extrémité 9a, 9b, ou 9c, 9d. Lorsque plusieurs connecteurs intermédiaires 9 sont prévus, ils sont similaires. Les connecteurs d'extrémité 9a, 9b, 9c, 9d sont différents des connecteurs intermédiaires 9.

Deux connecteurs d'extrémité 9a, 9b et d'éventuels connecteurs intermédiaires 9 peuvent être assemblés de façon à définir un premier collecteur 7 de fluide caloporteur. Deux autres connecteurs d'extrémité 9c, 9d et d'éventuels connecteurs intermédiaires 9 peuvent être assemblés de façon à définir un deuxième collecteur 7 de fluide caloporteur.

Chaque connecteur 9, 9a, 9b, 9c, 9d est assemblé à une paire 5 de plaques 3, 3' associée, formant ainsi un sous-ensemble de régulation thermique 100, ou 200, ou 300. Par ailleurs, les connecteurs 9, 9a, 9b, 9c, 9d sont avantageusement réalisés en matériau métallique, tel qu'en aluminium ou en alliage d'aluminium.

L'assemblage d'un connecteur, dans l'exemple décrit de deux connecteurs 9, 9a, 9b, 9c, 9d, à une paire 5 de plaques 3, 3' associée peut se faire par brasage. On assure ainsi une liaison étanche résistante entre les paires 5 de plaques 3, 3' et les connecteurs 9, 9a, 9b, 9c, 9d associés.

Chaque sous-ensemble de régulation thermique 100, ou 200, ou 300 est indépendant par rapport à un autre sous-ensemble de régulation thermique 100, ou 200, ou 300. Les différents sous-ensembles 100, 200, 300 peuvent ensuite être assemblés entre eux, ce qui permet d'obtenir un dispositif 1 modulaire.

Selon le mode de réalisation illustré, les connecteurs 9, 9a, 9b, 9c, 9d, sont agencés au niveau des ouvertures 38 des plaques 3, 3'. Chaque connecteur 9, 9a, 9b, 9c, 9d traverse deux ouvertures 38 en vis-à-vis des deux plaques 3, 3' d'une paire 5 associée.

Les connecteurs 9, 9a, 9b, 9c, 9d sont de forme complémentaire à la forme des ouvertures 38 avantageusement bordées de collets 39. Selon le mode de réalisation décrit les connecteurs 9, 9a, 9b, 9c, 9d présentent respectivement une forme générale tubulaire ou cylindrique dont l'axe de révolution est confondu avec l'axe d'empilement A1 à l'assemblage des connecteurs 9, 9a, 9b, 9c, 9d avec les paires 5 de plaques 3, 3'.

Les connecteurs 9, 9a, 9b, 9c, 9d sont conformés de sorte que des connecteurs assemblés à deux paires 5 de plaques adjacentes comprennent des parties mâle et femelle complémentaires, emmanchées l'une dans l'autre.

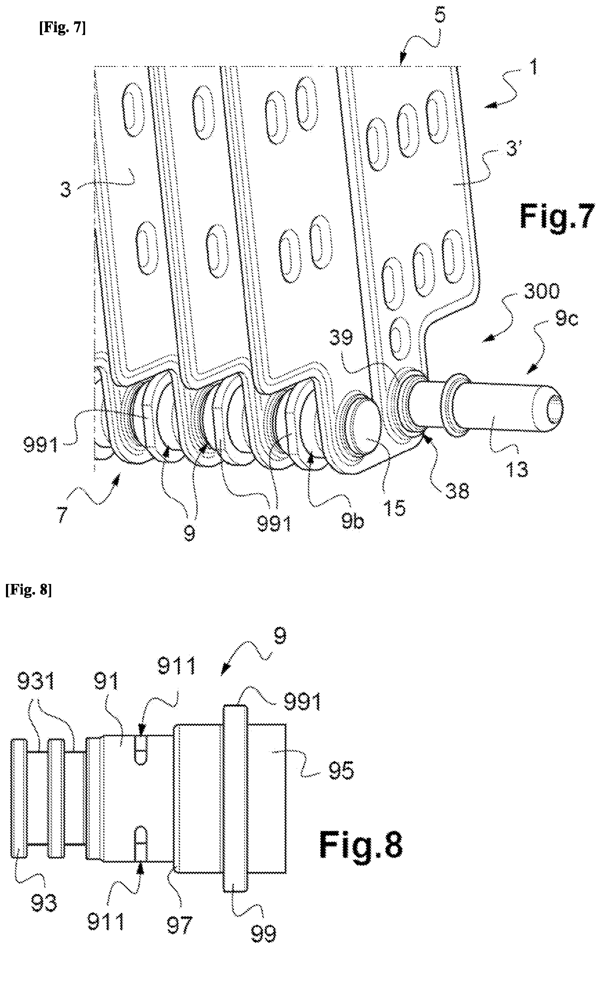

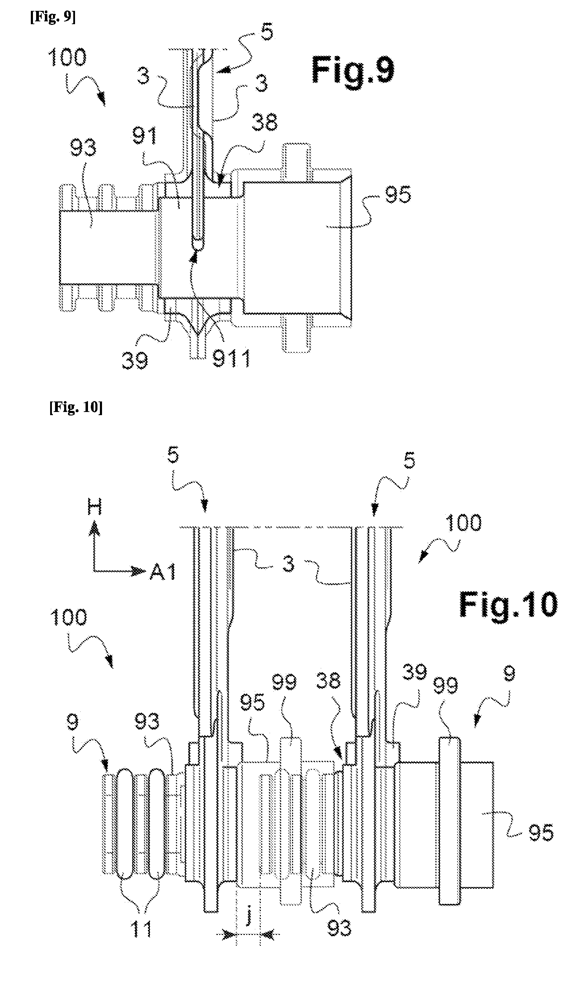

En référence aux figures 8 à 10, un connecteur intermédiaire 9 est décrit plus en détail. Un connecteur intermédiaire 9 peut être assemblé à une paire 5 associée de plaques 3 intermédiaires, formant ainsi un sous-ensemble de régulation thermique 100 indépendant.

Le connecteur intermédiaire 9 comprend une zone de distribution 91 présentant au moins une fente 911. La zone de distribution 91 présente avantageusement au moins deux fentes 911. Les fentes 911 débouchent dans le canal de circulation de fluide caloporteur défini par la paire 5 de plaques 3 associée.

Le connecteur intermédiaire 9 comporte d'un côté une partie mâle 93 et de l'autre côté une partie femelle 95. Les parties mâle 93 et femelle 95 sont par exemple disposées de part et d'autre de la zone de distribution 91.

La partie mâle 93 du connecteur intermédiaire 9 est équipé d'au moins un joint d'étanchéité 11. Il peut s'agir d'un joint d'étanchéité 11 compressible. Le joint d'étanchéité 11 par exemple réalisé en élastomère. Il est de forme complémentaire à la partie mâle 93 le recevant. Il peut s'agir notamment d'un joint d'étanchéité 11 torique.

Avantageusement, au moins deux joints d'étanchéité 11 sont disposés sur la partie mâle 93. À cet effet, la partie mâle 93 présente au moins une rainure, ici deux rainures 931, au niveau desquelles les joints d'étanchéité 11 sont disposés. De façon alternative, un joint d'étanchéité à au moins deux lèvres peut être prévu sur la partie mâle 93.

La zone de distribution 91 et les parties mâle 93 et femelle 95 du connecteur 9 sont avantageusement de sections différentes.

La partie mâle 93 et la zone de distribution 91 sont dimensionnées de façon à traverser les ouvertures 38 des deux plaques 3 de la paire 5 associée. À l'état assemblé, la zone de distribution 91 du connecteur intermédiaire 9 est agencée au niveau des ouvertures 38 des deux plaques 3. Les collets 39 des plaques 3 sont donc agencés autour de cette zone de distribution 91.

À titre d'exemple, la partie femelle 95 peut présenter un diamètre supérieur au diamètre de la zone de distribution 91. Le connecteur intermédiaire 9 présente ainsi un épaulement 97 entre la zone de distribution 91 et la partie femelle 95 configurée pour venir en butée contre le collet 39 d'une plaque 3 à l'assemblage du connecteur intermédiaire 9 avec une paire 5 de plaques 3. On assure ainsi le positionnement du connecteur 9 par rapport aux plaques 3.

À l'assemblage du connecteur intermédiaire 9 avec la paire 5 de plaques 3 associée, la partie femelle 95 est d'un côté de la paire 5 de plaques 3 tandis que la partie mâle 93 est de l'autre côté de la paire 5 de plaques 3.

La partie mâle 93 du connecteur intermédiaire 9 est destinée à coopérer avec une partie femelle 95 complémentaire d'un autre connecteur intermédiaire 9 ou d'un connecteur d'extrémité. De façon similaire, la partie femelle 95 du connecteur intermédiaire 9 est destinée à coopérer avec une partie mâle 93 complémentaire d'un autre connecteur intermédiaire 9 ou d'un connecteur d'extrémité. Chaque partie mâle 93 est destinée à être emmanchée avec une partie femelle 95 complémentaire.

Les parties mâle 93 et femelle 95 complémentaires sont emmanchées l'une dans l'autre selon l'axe d'empilement A1.

Les parties mâles 93 et femelles 95 sont dimensionnées de sorte qu'une partie mâle 93 est emmanchée avec une partie femelle 95 avec un jeu axial j entre la fin de la partie femelle 95 et l'extrémité de la partie mâle 93. La fin de la partie femelle 95 est par exemple définie par l'épaulement 97. Dans l'axe d'empilement A1, la longueur de la partie mâle 93 est donc inférieure à la longueur de la partie femelle 95. La longueur de la partie mâle 93 est toutefois choisie suffisante pour permettre de coulisser les connecteurs 9 l'un par rapport à l'autre et de les maintenir assemblés. De plus, les parties mâles 93 et femelles 95 sont dimensionnées pour permettre de comprimer les paires 5 de plaques 3, 3' après interposition de composants électroniques et/ou électriques.

La longueur d'une partie mâle 93 et la profondeur d'une partie femelle 95 sont donc calculées, de sorte qu'à l'emmanchement de l'une dans l'autre, la partie mâle 93 ne vienne pas en butée contre la fin de la partie femelle 95. Cela permet par exemple de définir un jeu minimal.

En outre, les parties mâle 93 et femelle 95 sont avantageusement dimensionnées de sorte qu'à l'assemblage, les joints d'étanchéité 11 portés par la partie mâle 93 soient toujours à l'intérieur du connecteur femelle 95. On peut rajouter à cela une éventuelle marge, par exemple de façon non limitative de l'ordre de 0,5mm ou 1mm. Ceci permet de garantir une zone d'étanchéité suffisante. Cela permet par exemple de définir un jeu maximal.

De plus, le jeu axial j est défini en fonction des tolérances d'assemblage du connecteur 9 dans la plaque, en fonction des tolérances d'usinage du connecteur 9, et en outre en fonction des tolérances du composant électroniques et/ou électriques, voire d'un éventuel isolant électrique.

Ceci confère une souplesse de montage selon l'axe d'empilement A1, lors de l'interposition d'un composant électronique et/ou électrique à réguler thermiquement entre deux paires 5 de plaques 3, et autorise une compression des paires 5 de plaques 3 entre lesquelles les composants électroniques et/ou électriques sont destinés à être disposés, afin d'assurer le contact thermique nécessaire à la régulation thermique, notamment au refroidissement, de tels composants.

Le connecteur intermédiaire 9 comprend de plus une collerette 99. Cette collerette 99 est par exemple formée autour de la partie femelle 95. Une telle collerette 99 est avantageusement destinée à coopérer avec un outil d'assemblage, pour l'emmanchement de deux connecteurs complémentaires. La collerette 99 présente dans cet exemple une forme générale annulaire.

La collerette 99 présente de façon avantageuse une surface de détrompage 991. Cela permet d'assurer le montage du connecteur 9 dans une position précise, notamment avant le brasage avec la paire 5 de plaques 3 associée. La surface de détrompage 991 peut de façon non limitative être formée par un méplat.

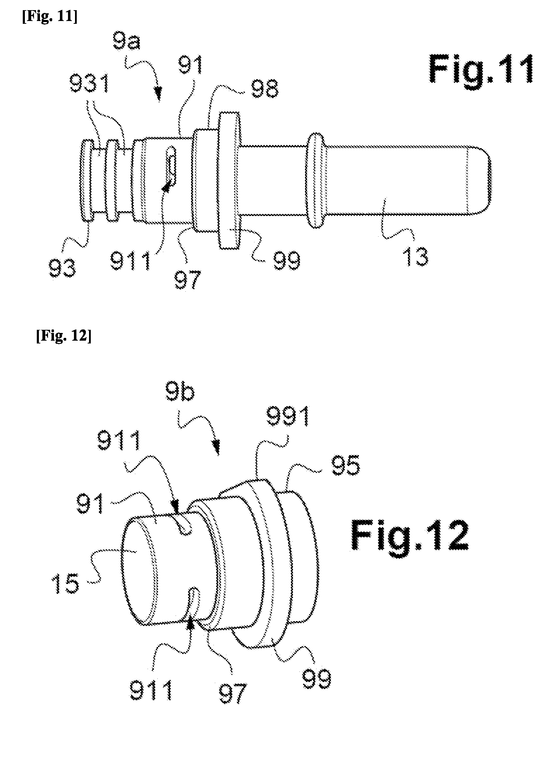

Des exemples de réalisation des connecteurs d'extrémité 9a, 9b, 9c, 9d sont décrits plus en détail en référence aux figures 11 à 15.

Les connecteurs d'extrémité 9a, 9b, 9c, 9d comprennent respectivement une zone de distribution 91 présentant au moins une fente 911, de préférence au moins deux fentes 911. La zone de distribution 91 d'un connecteur d'extrémité 9a, 9b, 9c, 9d peut être telle que définie précédemment pour un connecteur intermédiaire 9. Les zones de distribution 91 de tous les connecteurs 9, 9a, 9b, 9c, 9d peuvent être identiques.

Les fentes 911 des connecteurs 9, 9a, 9b, 9c, 9d débouchant dans les canaux de circulation de fluide caloporteur définis par les paires 5 de plaques 3, 3', sont calibrées, dimensionnées, pour assurer une distribution optimisée dans tous les canaux de circulation de fluide caloporteur. À cet effet, les deux fentes 911 de chaque zone de distribution 91 peuvent être dimensionnées de façon à présenter un ratio de la section totale de passage du fluide à travers les deux fentes 911 sur la section de passage totale dans le collecteur de fluide caloporteur, qui se situe entre 12% et 25%, en particulier entre 16% et 21%.

Lorsque les connecteurs 9, 9a, 9b, 9c, 9d sont de forme générale cylindrique, les fentes 911 peuvent s'étendre sur une circonférence de la zone de distribution 91 selon un angle cumulé entre 30° et 180°.

Par ailleurs, contrairement au connecteur intermédiaire 9 précédemment décrit, les connecteurs d'extrémité 9a, 9b, 9c, 9d ne comprennent pas à la fois une partie mâle 93 et une partie femelle 95. Chaque connecteur d'extrémité 9a, 9b, 9c, 9d comprend l'une ou l'autre, c'est-à-dire soit une partie mâle 93, soit une partie femelle 95.

En se référant également à la figure 1, au moins l'un des collecteurs 7, selon le mode de réalisation décrit chaque collecteur 7, de fluide caloporteur, comporte un premier connecteur d'extrémité 9a, respectivement 9d, comprenant une partie mâle 93 et un deuxième connecteur d'extrémité 9b, respectivement 9c, comprenant une partie femelle 95.

Les parties mâle 93 et femelle 95 sont réalisées conformément à la description précédente relative au connecteur intermédiaire 9. Ainsi, toutes les parties mâles 93 des connecteurs 9, 9a, 9d sont identiques. Toutes les parties femelles 95 des connecteurs 9, 9b, 9c sont identiques. La description précédente des parties mâle 93 et femelle 95, ainsi que du jeu axial à l'emmanchement, s'applique donc aux parties mâle 93 et femelle 95 respectives des connecteurs d'extrémité 9, 9a, 9b, 9c, 9d.

Chaque partie mâle 93 est destinée à être emmanchée avec une partie femelle 95 complémentaire. La partie mâle 93 du premier connecteur d'extrémité 9a, respectivement 9d, est destinée à coopérer avec une partie femelle 95 complémentaire d'un autre connecteur, qui peut être un connecteur intermédiaire 9 ou le deuxième connecteur d'extrémité 9b, respectivement 9c. De façon similaire, la partie femelle 95 du deuxième connecteur d'extrémité 9b, respectivement 9c, est destinée à coopérer avec une partie mâle 93 complémentaire d'un autre connecteur, qui peut être un connecteur intermédiaire 9 ou le premier connecteur d'extrémité 9a, respectivement 9d.

Comme décrit précédemment, une partie mâle 93 d'un connecteur 9, 9a, 9d, est destinée à être emmanchée avec une partie femelle 95 d'un connecteur 9, 9b, 9c, avec un jeu axial entre la fin de la partie femelle 95 et l'extrémité de la partie mâle 93, permettant de coulisser les connecteurs 9, 9a, 9b, 9c, 9d, selon l'axe d'empilement A1, et de comprimer les paires 5 de plaques 3, 3' entre lesquelles les composants électroniques et/ou électriques sont destinés à être disposés.

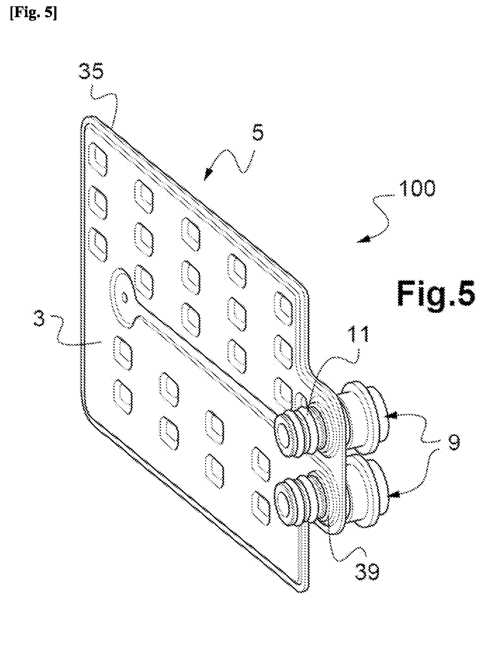

Au moins un joint d'étanchéité 11 tel que décrit précédemment, en référence aux figures 4 et 5, est également disposé sur la partie mâle 93 du premier connecteur d'extrémité 9a, respectivement 9d.

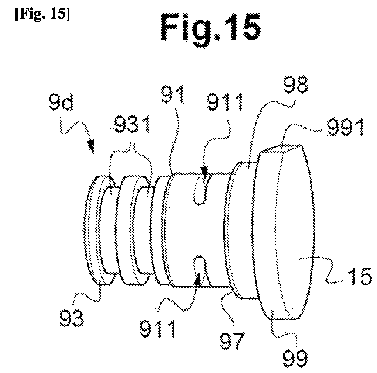

Par ailleurs, de façon à assurer le positionnement par rapport à la plaque d'extrémité 3', du premier connecteur d'extrémité 9a (figure 11), respectivement 9d (figure 15), présentant la partie mâle 93 mais dépourvu de partie femelle, ce premier connecteur d'extrémité 9a, respectivement 9d, peut comporter un épaulement 97 comme décrit précédemment entre la zone de distribution 91 et une section de positionnement 98 de diamètre supérieur au diamètre de la zone de distribution 91 configurée pour venir en butée contre le collet 39 de la plaque d'extrémité 3'.

Les différents sous-ensembles de régulation thermique 100, 200, 300 des figures 5 à 7, peuvent ainsi être assemblés mécaniquement par l'emmanchement des connecteurs 9, 9a, 9b, 9c, 9d, décrits en référence aux figures 8 à 15, par exemple à température ambiante, en garantissant l'étanchéité entre les connecteurs 9, 9a, 9b, 9c, 9d, grâce à l'interposition des joints d'étanchéité 11 rapportés sur les parties mâles 93 des connecteurs 9, 9a, 9d, et qui sont comprimés par les parties femelles 95 complémentaires des connecteurs 9, 9b, 9c, à l'assemblage.

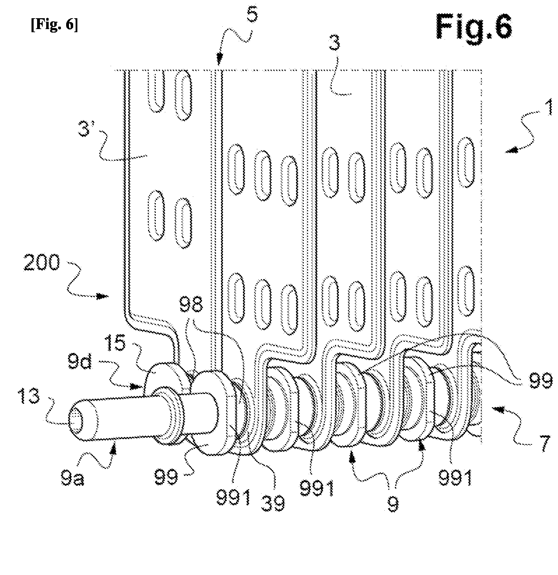

De plus, l'un des connecteurs d'extrémité définissant un collecteur 7 de fluide caloporteur (voir figures 6, 7) est configuré pour être raccordé à un circuit du fluide caloporteur. Au moins une connectique 13 de raccordement au circuit du fluide caloporteur est prévue à cet effet en extrémité d'au moins un, ici de chaque collecteur 7 de fluide caloporteur, pour assurer la liaison entre le dispositif 1 et le circuit du fluide caloporteur. La connectique 13 peut présenter une forme générale creuse, telle qu'une forme cylindrique. À l'état assemblé, la connectique 13 s'étend depuis une plaque d'extrémité 3' à l'opposé de l'empilement du dispositif 1.

Une telle connectique 13 est avantageusement formée ou réalisée d'une seule pièce avec un connecteur d'extrémité.

Selon le mode de réalisation illustré sur les figures 6 et 7, le premier connecteur d'extrémité 9a définissant en partie l'un des collecteurs 7 de fluide caloporteur, notamment avec le deuxième connecteur d'extrémité 9b, peut présenter une telle connectique 13. De même, le deuxième connecteur d'extrémité 9c définissant en partie l'autre collecteur 7 de fluide caloporteur, notamment avec le premier connecteur d'extrémité 9d, peut présenter une telle connectique 13.

En référence aux figures 11, et 13, 14, la connectique 13 peut être formée sur un connecteur d'extrémité présentant une partie mâle 93 ou au contraire une partie femelle 95. Dans ce cas, la connectique 13 est disposée de l'autre côté de la zone de distribution 91 qui est opposé au côté présentant la partie mâle 93 ou femelle 95.

Dans l'exemple de la figure 11, le premier connecteur d'extrémité 9a comprend la zone de distribution 91, la partie mâle 93 d'un côté de la zone de distribution 91, et de l'autre côté la connectique 13.

En outre, le premier connecteur d'extrémité 9a peut comprendre une collerette 99, telle que définie précédemment, disposée entre la connectique 13 et la zone de distribution 91, ou la section de positionnement 98. Cette collerette 99 permet également de faciliter l'assemblage du premier connecteur d'extrémité 9a.

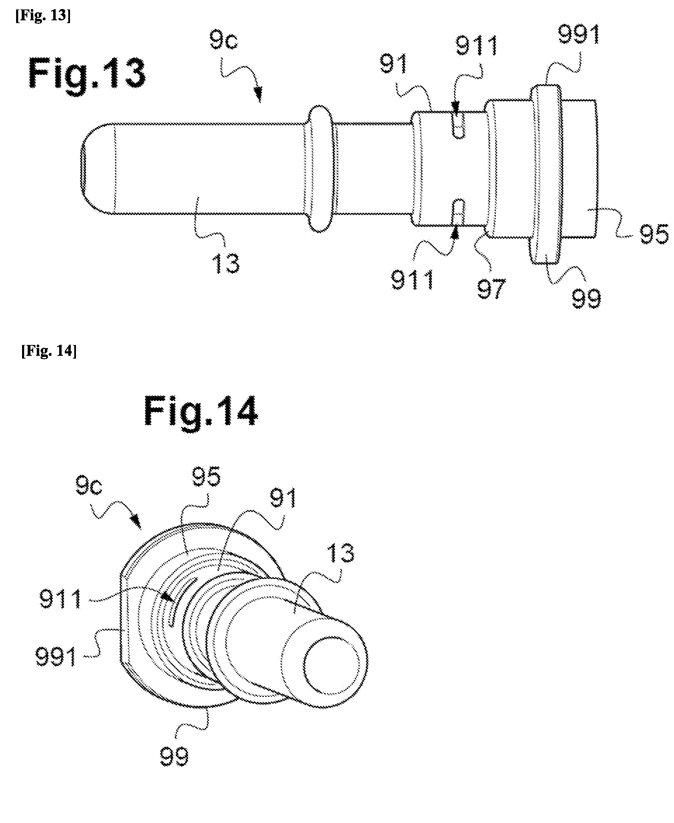

Dans l'exemple des figures 13 et 14, le deuxième connecteur d'extrémité 9c comprend la zone de distribution 91, la partie femelle 95 d'un côté de la zone de distribution 91, et de l'autre côté la connectique 13.

L'autre connecteur d'extrémité définissant un collecteur 7 qui n'est pas muni d'un telle connectique 13, est obturé d'un côté, plus précisément du côté opposé à l'empilement du dispositif 1, comme mieux visible sur les figures 1, 6 et 7. Ce connecteur d'extrémité peut comprendre à cet effet une paroi borgne 15. La paroi borgne 15 obture une ouverture 38 de la plaque d'extrémité 3' lorsque le connecteur d'extrémité est assemblé avec cette plaque d'extrémité 3'. Selon une alternative non représentée, on pourrait éventuellement envisager que le connecteur d'extrémité soit obturé par la plaque d'extrémité 3' qui ne présenterait pas d'ouverture.

Selon le mode de réalisation illustré sur les figures 6 et 7, il s'agit du deuxième connecteur d'extrémité 9b définissant en partie l'un des collecteurs 7 de fluide caloporteur, notamment avec le premier connecteur d'extrémité 9a, respectivement du premier connecteur d'extrémité 9d définissant en partie l'autre collecteur 7 de fluide caloporteur, notamment avec le deuxième connecteur d'extrémité 9c.

En référence aux figures 12 et 15, il peut s'agir d'un connecteur d'extrémité présentant une partie mâle 93 ou au contraire une partie femelle 95. Dans ce cas, l'obturation se fait du côté de la zone de distribution 91 qui est opposé au côté présentant la partie mâle 93 ou femelle 95.

Dans l'exemple de la figure 12, le deuxième connecteur d'extrémité 9b comprend la zone de distribution 91, la partie femelle 95 d'un côté de la zone de distribution 91, et de l'autre côté la paroi borgne 15.

Dans l'exemple de la figure 15, le premier connecteur d'extrémité 9d comprend la zone de distribution 91, la partie mâle 93 d'un côté de la zone de distribution 91, et de l'autre côté la paroi borgne 15.

En outre, ce premier connecteur d'extrémité 9d peut comprendre une collerette 99, telle que définie précédemment. La paroi borgne 15 peut être agencée de façon à obturer la collerette 99. Dans cet exemple, la section de positionnement 98 est disposée entre la collerette 99 et la zone de distribution 91. Cette collerette 99 permet également de faciliter l'assemblage du premier connecteur d'extrémité 9d.

Ainsi, en référence aux figures 6 et 7, tous les connecteurs 9, 9a, 9b, 9c, 9d, même dépourvus de partie femelle, peuvent présenter une telle collerette 99. À l'assemblage, les surfaces de détrompage 991 de l'ensemble des connecteurs 9 et 9a, 9b, ou 9c, 9d, définissant un collecteur 7 de fluide caloporteur sont toutes disposées d'un même côté du dispositif 1.

En référence à l'ensemble des figures, le dispositif 1 de régulation thermique tel que décrit précédemment peut être assemblé selon un procédé d'assemblage comportant les étapes décrites ci-après.

Un nombre prédéfini de plaques 3, 3' dont deux plaques d'extrémité 3' peut être assemblé de façon à former au moins deux paires 5 de plaques 3, 3', chaque paire 5 définissant entre elles un canal de circulation de fluide caloporteur.

Au moins un connecteur 9, 9a, 9b, 9c, 9d, peut ensuite être assemblé à chaque paire 5 de plaques 3, 3'.

En particulier, au moins un premier connecteur d'extrémité 9a, respectivement 9d, peut être assemblé à une paire 5 comprenant une plaque d'extrémité 3', et au moins un deuxième connecteur d'extrémité 9b, respectivement 9c, peut être assemblé à une paire 5 comprenant une autre plaque d'extrémité 3'. Selon le nombre de plaques 3, 3', autrement dit si le dispositif 1 comporte plus de deux paires 5 de plaques 3, 3', au moins un connecteur intermédiaire 9 peut être assemblé à une paire 5 de plaques 3 intermédiaires.

Selon le mode de réalisation décrit, deux connecteurs 9, 9a, 9b, 9c, 9d, peuvent être assemblés à une même paire 5 de plaques 3, 3', associée. Ainsi, deux connecteurs d'extrémité 9a et 9d, respectivement 9b et 9c, peuvent être assemblés à une même paire 5 de plaques 3, 3', associée. Si plus de deux paires 5 de plaques 3, 3' sont prévues, deux connecteurs intermédiaires 9 peuvent être assemblés à une même paire 5 associée de plaques 3 intermédiaires.

La ou les fentes 911 de la zone de distribution 91 de chaque connecteur 9, 9a, 9b, 9c, 9d débouchent dans le canal de circulation de fluide caloporteur défini par la paire 5 de plaques 3, 3' associée.

Les connecteurs 9, 9a, 9b, 9c, 9d, sont assemblés à une paire 5 de plaques 3, 3' associée par exemple par brasage.

Au moins un joint d'étanchéité 11, de préférence deux joints d'étanchéité 11, peuvent être disposés sur les parties mâles 93 des connecteurs, notamment des premiers connecteurs d'extrémité 9a, 9d, et du ou des éventuels connecteurs intermédiaires 9.

On obtient différents sous-ensembles de régulation thermique 100, 200, 300. De tels sous-ensembles 100, 200, 300 indépendants peuvent être livrés par exemple à un constructeur automobile pour l'assemblage final. En alternative, ils peuvent être assemblés entre eux avant d'être livrés pour l'assemblage final avec le ou les composants électroniques et/ou électriques susceptibles de générer de la chaleur en fonctionnement.

Les sous-ensembles de régulation thermique 100, 200, 300 peuvent être assemblés via leurs connecteurs 9, 9a, 9b, 9c, 9d, en emmanchant les parties mâle 93 et femelle 95 des connecteurs des paires 5 de plaques 3, 3' adjacentes. L'étape d'assemblage des connecteurs 9, 9a, 9b, 9c, 9d est une étape d'assemblage mécanique. Une telle étape d'assemblage mécanique peut être réalisée à température ambiante, contrairement à une étape d'assemblage par brasage par passage dans un four.

Le dispositif 1 ainsi obtenu, comprend au moins deux paires 5 de plaques 3, 3' assemblées aux collecteurs 7, en particulier une pluralité de paires 5 de plaques 3, 3', et présente une forme générale de peigne. Les paires 5 de plaques 3, 3' du dispositif 1 sont avantageusement espacées selon l'axe d'empilement A1, d'un écart prédéfini, qui peut être standard.

Le procédé est dépourvu d'étape de brasage de l'ensemble du dispositif 1 ainsi obtenu. La fonction d'étanchéité n'est pas destinée à être assurée par brasage.

Les joints d'étanchéité 11 une fois assemblés au dispositif 1 restent des pièces distinctes, non liées de façon irréversible aux plaques 3, 3', même après l'assemblage des sous-ensembles de régulation thermique 100, 200, 300.

Le ou les composants électroniques et/ou électriques peuvent être interposés dans le dispositif 1 obtenu selon ce procédé d'assemblage, afin de former un module électrique par exemple à monter dans un véhicule automobile.

Les composants électroniques et/ou électriques peuvent être insérés simultanément, ou en alternative un à un, entre les paires 5 de plaques 3, 3'. De façon à faciliter cette insertion, l'écart prédéfini entre les paires 5 de plaques 3, 3' peut être supérieur à la dimension desdits composants dans l'axe d'empilement A1. De façon optionnelle, si l'écart entre les paires 5 de plaques 3, 3' n'est pas suffisant pour permettre l'insertion des composants électroniques et/ou électriques, les paires 5 de plaques 3, 3' peuvent être écartées ou éloignées les unes des autres selon l'axe d'empilement A1 en faisant coulisser les connecteurs 9, 9a, 9b, 9c, 9d. Après insertion, l'ensemble peut être comprimé selon l'axe d'empilement A1, de préférence des deux côtés du dispositif 1.

Ainsi, les connecteurs creux complémentaires 9, 9a, 9b, 9c, 9d définissant les collecteurs 7 de fluide caloporteur en étant emmanchés les uns dans les autres, offrent une souplesse de montage dans le sens de l'empilement des paires 5 de plaques 3, 3', ce qui permet de comprimer l'ensemble, lorsque les composants sont insérés entre les paires 5 de plaques 3, 3', pour assurer le maintien en position des composants par les paires 5 de plaques 3, 3', et assurer le contact thermique nécessaire à la régulation thermique tel que le refroidissement des composants.

En fonctionnement, le dispositif 1 est alimenté en fluide caloporteur via un collecteur 7 d'entrée de fluide caloporteur, et le fluide caloporteur est distribué dans chaque canal de circulation de fluide caloporteur via les fentes 911 d'un ou chaque connecteur 9, 9a, 9b, 9c, 9d définissant ce collecteur 7 d'entrée de fluide caloporteur, puis le fluide caloporteur est évacué du canal de circulation de fluide caloporteur via les fentes 911 d'un autre connecteur 9, 9a, 9b, 9c, 9d définissant cette fois le collecteur 7 de sortie de fluide caloporteur.

L'étanchéité est assurée au niveau des connecteurs 9, 9a, 9b, 9c, 9d définissant les collecteurs 7 de fluide caloporteur grâce aux joints d'étanchéité 11 équipant les parties mâles 93, tout en permettant de comprimer les paires 5 de plaques 3, 3' sur les composants à l'assemblage final.

## Revendications

1. Dispositif (1) de régulation thermique d'au moins un composant électronique et/ou électrique, notamment pour véhicule automobile, ledit dispositif (1) comportant :
- un empilement d'au moins deux paires (5) de plaques (3, 3'), ledit au moins un composant étant destiné à être agencé entre les deux paires (5) de plaques (3, 3'), les plaques (3, 3') définissant par paire (5) un canal de circulation de fluide caloporteur, et
- au moins un collecteur (7) de fluide caloporteur, en communication fluidique avec les canaux de circulation de fluide caloporteur définis par les paires (5) de plaques (3, 3'), ledit au moins un collecteur (7) de fluide caloporteur comportant au moins deux connecteurs (9, 9a, 9b, 9c, 9d) creux complémentaires, tels que :
- chaque connecteur (9, 9a, 9b, 9c, 9d) est assemblé à une paire (5) de plaques (3, 3') associée et comprend une zone de distribution (91) présentant au moins une fente (911) débouchant dans le canal de circulation de fluide caloporteur défini par la paire (5) de plaques (3, 3'), et
- les connecteurs (9, 9a, 9b, 9c, 9d) assemblés à deux paires (5) de plaques (3, 3') adjacentes comprennent des parties mâle (93) et femelle (95) complémentaires, emmanchées l'une dans l'autre, la partie mâle (93) portant au moins un joint d'étanchéité (11)
- ledit dispositif étant **caractérisé en ce que les plaques (3, 3') sont agencées selon un axe d'empilement (A1) et dans lequel les parties mâle (93) et femelle (95) complémentaires des connecteurs (9, 9a, 9b, 9c, 9d) sont emmanchées l'une dans l'autre selon l'axe d'empilement (A1), avec un jeu axial (j) entre la fin de la partie femelle (95) et l'extrémité de la partie mâle (93), la partie mâle (93) porte au moins deux joints d'étanchéité (11), ou un joint d'étanchéité à au moins deux lèvres..**

2. Dispositif (1) selon la revendication précédente, dans lequel ledit au moins un collecteur (7) de fluide caloporteur comporte deux connecteurs d'extrémité (9a, 9b ; 9c, 9d), dont un premier connecteur d'extrémité (9a ; 9d) comprenant une partie mâle (93) et un deuxième connecteur d'extrémité (9b ; 9c) comprenant une partie femelle (95), l'un des connecteurs d'extrémité (9a ; 9c) étant configuré pour être raccordé à un circuit du fluide caloporteur, l'autre connecteur d'extrémité (9b ; 9d) étant obturé d'un côté opposé à l'empilement de plaques (3, 3').

3. Dispositif (1) selon l'une des revendications précédentes, comportant au moins une paire (5) de plaques (3) intermédiaires entre deux plaques d'extrémité (3'), assemblée avec un connecteur (9) intermédiaire comportant d'un côté une partie mâle (93) et de l'autre côté une partie femelle (95).

4. Dispositif (1) selon l'une des revendications précédentes, dans lequel les connecteurs (9, 9a, 9b, 9c, 9d) présentent respectivement au moins deux fentes (911) débouchant dans le canal de circulation de fluide caloporteur défini par la paire de plaques associée.

5. Dispositif (1) selon la revendication précédente, dans lequel les deux fentes (911) sont dimensionnées de façon à présenter un ratio de la section totale de passage du fluide caloporteur à travers les deux fentes (911) du connecteur (9, 9a, 9b, 9c, 9d) sur la section de passage du fluide caloporteur dans le collecteur (7) de fluide caloporteur, entre 12% et 25%, en particulier entre 16% et 21%.

6. Dispositif (1) selon l'une des revendications précédentes, dans lequel les connecteurs (9, 9a, 9b, 9c, 9d) présentent respectivement une collerette (99).

7. Dispositif (1) selon l'une des revendications précédentes, dans lequel les plaques (3, 3') présentent chacune au moins une ouverture (38), et dans lequel les connecteurs (9, 9a, 9b, 9c, 9d) sont assemblés aux paires (5) de plaques (3, 3') de sorte que la zone de distribution (91) de chaque connecteur (9, 9a, 9b, 9c, 9d) est agencée au niveau des ouvertures (38) des plaques (3, 3') d'une paire (5) associée.

8. Procédé d'assemblage d'un dispositif (1) de régulation thermique selon l'une des revendications précédentes, comportant les étapes suivantes :
- assembler au moins deux paires (5) de plaques (3, 3') définissant entre elles un canal de circulation de fluide caloporteur,
- assembler au moins un premier connecteur (9, 9a, 9b, 9c, 9d) à une première paire (5) de plaques (3, 3') associée et un deuxième connecteur (9, 9a, 9b, 9c, 9d) à une deuxième paire (5) de plaques (3, 3') associée, de sorte que ladite au moins une fente (911) de la zone de distribution (91) de chaque connecteur (9, 9a, 9b, 9c, 9d) débouche dans le canal de circulation de fluide caloporteur défini par la paire (5) de plaques (3, 3') associée,
- disposer au moins un joint d'étanchéité (11) sur la partie mâle (93) d'au moins un des connecteurs (9, 9a, 9d), et
- assembler les connecteurs (9, 9a, 9b, 9c, 9d) entre eux en emmanchant les parties mâle (93) et femelle (97) des connecteurs (9, 9a, 9b, 9c, 9d) des paires de plaques (3, 3') adjacentes.

## Patentansprüche

1. Vorrichtung (1) zur thermischen Regulierung mindestens einer elektronischen und/oder elektrischen Komponente, insbesondere für ein Kraftfahrzeug, wobei die Vorrichtung (1) umfasst:
- eine Stapelung von mindestens zwei Plattenpaaren (5) (3, 3'), wobei die mindestens eine Komponente dazu bestimmt ist, zwischen den zwei Plattenpaaren (5) (3, 3') angeordnet zu werden, wobei die Platten (3, 3') paarweise (5) einen Wärmeträgerfluidzirkulationskanal definieren, und
- mindestens einen Wärmeträgerfluidkollektor (7), der in Fluidverbindung mit den durch die Plattenpaare (5) (3, 3') definierten Wärmeträgerfluidzirkulationskanälen steht,
wobei der mindestens eine Wärmeträgerfluidkollektor (7) mindestens zwei komplementäre Hohlverbinder (9, 9a, 9b, 9c, 9d) umfasst, so dass:
- jeder Verbinder (9, 9a, 9b, 9c, 9d) an ein zugehöriges Plattenpaar (5) (3, 3') montiert ist und eine Verteilungszone (91) umfasst, die mindestens einen Schlitz (911) aufweist, der in den durch das Plattenpaar (5) (3, 3') definierten Wärmeträgerfluidzirkulationskanal mündet, und
- die an zwei benachbarten Plattenpaaren (5) (3, 3') montierten Verbinder (9, 9a, 9b, 9c, 9d) komplementäre männliche (93) und weibliche (95) Teile umfassen, die ineinander gesteckt sind, wobei das männliche Teil (93) mindestens eine Dichtung (11) trägt,
wobei die Vorrichtung **dadurch gekennzeichnet ist, dass** die Platten (3, 3') entlang einer Stapelachse (A1) angeordnet sind und wobei die komplementären männlichen (93) und weiblichen (95) Teile der Verbinder (9, 9a, 9b, 9c, 9d) entlang der Stapelachse (A1) ineinander gesteckt sind, mit einem axialen Spiel (j) zwischen dem Ende des weiblichen Teils (95) und dem Ende des männlichen Teils (93), wobei das männliche Teil (93) mindestens zwei Dichtungen (11) oder eine Dichtung mit mindestens zwei Lippen trägt.

2. Vorrichtung (1) nach dem vorhergehenden Anspruch, wobei der mindestens eine Wärmeträgerfluidkollektor (7) zwei Endverbinder (9a, 9b; 9c, 9d) umfasst, von denen ein erster Endverbinder (9a; 9d) einen männlichen Teil (93) und ein zweiter Endverbinder (9b; 9c) einen weiblichen Teil (95) umfasst, wobei einer der Endverbinder (9a; 9c) konfiguriert ist, um an einen Wärmeträgerfluidkreislauf angeschlossen zu werden, wobei der andere Endverbinder (9b; 9d) auf einer dem Plattenstapel (3, 3') gegenüberliegenden Seite verschlossen ist.

3. Vorrichtung (1) nach einem der vorhergehenden Ansprüche, umfassend mindestens ein Paar (5) Zwischenplatten (3) zwischen zwei Endplatten (3'), montiert mit einem Zwischenverbinder (9), der auf einer Seite einen männlichen Teil (93) und auf der anderen Seite einen weiblichen Teil (95) aufweist.

4. Vorrichtung (1) nach einem der vorhergehenden Ansprüche, wobei die Verbinder (9, 9a, 9b, 9c, 9d) jeweils mindestens zwei Schlitze (911) aufweisen, die in den durch das zugehörige Plattenpaar definierten Wärmeträgerfluidzirkulationskanal münden.

5. Vorrichtung (1) nach dem vorhergehenden Anspruch, wobei die zwei Schlitze (911) so dimensioniert sind, dass sie ein Verhältnis des Gesamtdurchgangsquerschnitts des Wärmeträgerfluids durch die zwei Schlitze (911) des Verbinders (9, 9a, 9b, 9c, 9d) zum Durchgangsquerschnitt des Wärmeträgerfluids im Wärmeträgerfluidkollektor (7) zwischen 12% und 25%, insbesondere zwischen 16% und 21% aufweisen.

6. Vorrichtung (1) nach einem der vorhergehenden Ansprüche, wobei die Verbinder (9, 9a, 9b, 9c, 9d) jeweils einen Flansch (99) aufweisen.

7. Vorrichtung (1) nach einem der vorhergehenden Ansprüche, wobei die Platten (3, 3') jeweils mindestens eine Öffnung (38) aufweisen und wobei die Verbinder (9, 9a, 9b, 9c, 9d) an die Plattenpaare (5) (3, 3') so montiert sind, dass die Verteilungszone (91) jedes Verbinders (9, 9a, 9b, 9c, 9d) auf Höhe der Öffnungen (38) der Platten (3, 3') eines zugehörigen Paares (5) angeordnet ist.

8. Verfahren zur Montage einer Vorrichtung (1) zur thermischen Regulierung nach einem der vorhergehenden Ansprüche, umfassend die folgenden Schritte:
- Montieren von mindestens zwei Plattenpaaren (5) (3, 3'), die zwischen sich einen Wärmeträgerfluidzirkulationskanal definieren,
- Montieren mindestens eines ersten Verbinders (9, 9a, 9b, 9c, 9d) an ein erstes zugehöriges Plattenpaar (5) (3, 3') und eines zweiten Verbinders (9, 9a, 9b, 9c, 9d) an ein zweites zugehöriges Plattenpaar (5) (3, 3'), so dass der mindestens eine Schlitz (911) der Verteilungszone (91) jedes Verbinders (9, 9a, 9b, 9c, 9d) in den durch das zugehörige Plattenpaar (5) (3, 3') definierten Wärmeträgerfluidzirkulationskanal mündet,
- Anbringen mindestens einer Dichtung (11) auf dem männlichen Teil (93) mindestens eines der Verbinder (9, 9a, 9d), und
- Zusammenfügen der Verbinder (9, 9a, 9b, 9c, 9d) durch Ineinanderstecken der männlichen (93) und weiblichen (97) Teile der Verbinder (9, 9a, 9b, 9c, 9d) der benachbarten Plattenpaare (3, 3').

## Claims

1. Device (1) for thermal regulation of at least one electronic and/or electrical component, particularly for a motor vehicle, said device (1) comprising:
- a stack of at least two pairs (5) of plates (3, 3'), said at least one component being intended to be arranged between the two pairs (5) of plates (3, 3'), the plates (3, 3') defining in pairs (5) a heat transfer fluid circulation channel, and
- at least one heat transfer fluid collector (7), in fluid communication with the heat transfer fluid circulation channels defined by the pairs (5) of plates (3, 3'),
said at least one heat transfer fluid collector (7) comprising at least two complementary hollow connectors (9, 9a, 9b, 9c, 9d), such that:
- each connector (9, 9a, 9b, 9c, 9d) is assembled to an associated pair (5) of plates (3, 3') and includes a distribution zone (91) having at least one slot (911) opening into the heat transfer fluid circulation channel defined by the pair (5) of plates (3, 3'), and
- the connectors (9, 9a, 9b, 9c, 9d) assembled to two adjacent pairs (5) of plates (3, 3') include complementary male (93) and female (95) parts, fitted into one another, the male part (93) carrying at least one sealing gasket (11)
said device being **characterized in that** the plates (3, 3') are arranged along a stacking axis (A1) and wherein the complementary male (93) and female (95) parts of the connectors (9, 9a, 9b, 9c, 9d) are fitted into one another along the stacking axis (A1), with an axial clearance (j) between the end of the female part (95) and the end of the male part (93), the male part (93) carries at least two sealing gaskets (11), or a sealing gasket with at least two lips.

2. Device (1) according to the preceding claim, wherein said at least one heat transfer fluid collector (7) comprises two end connectors (9a, 9b; 9c, 9d), including a first end connector (9a; 9d) comprising a male part (93) and a second end connector (9b; 9c) comprising a female part (95), one of the end connectors (9a; 9c) being configured to be connected to a heat transfer fluid circuit, the other end connector (9b; 9d) being sealed on a side opposite to the stack of plates (3, 3').

3. Device (1) according to one of the preceding claims, comprising at least one pair (5) of intermediate plates (3) between two end plates (3'), assembled with an intermediate connector (9) having on one side a male part (93) and on the other side a female part (95).

4. Device (1) according to one of the preceding claims, wherein the connectors (9, 9a, 9b, 9c, 9d) respectively have at least two slots (911) opening into the heat transfer fluid circulation channel defined by the associated pair of plates.

5. Device (1) according to the preceding claim, wherein the two slots (911) are dimensioned so as to present a ratio of the total cross-section of heat transfer fluid passage through the two slots (911) of the connector (9, 9a, 9b, 9c, 9d) to the cross-section of heat transfer fluid passage in the heat transfer fluid collector (7), between 12% and 25%, in particular between 16% and 21%.

6. Device (1) according to one of the preceding claims, wherein the connectors (9, 9a, 9b, 9c, 9d) respectively have a flange (99).

7. Device (1) according to one of the preceding claims, wherein the plates (3, 3') each have at least one opening (38), and wherein the connectors (9, 9a, 9b, 9c, 9d) are assembled to the pairs (5) of plates (3, 3') such that the distribution zone (91) of each connector (9, 9a, 9b, 9c, 9d) is arranged at the level of the openings (38) of the plates (3, 3') of an associated pair (5).

8. Method of assembling a thermal regulation device (1) according to one of the preceding claims, comprising the following steps:
- assembling at least two pairs (5) of plates (3, 3') defining between them a heat transfer fluid circulation channel,
- assembling at least one first connector (9, 9a, 9b, 9c, 9d) to a first associated pair (5) of plates (3, 3') and a second connector (9, 9a, 9b, 9c, 9d) to a second associated pair (5) of plates (3, 3'), such that said at least one slot (911) of the distribution zone (91) of each connector (9, 9a, 9b, 9c, 9d) opens into the heat transfer fluid circulation channel defined by the associated pair (5) of plates (3, 3'),
- placing at least one sealing gasket (11) on the male part (93) of at least one of the connectors (9, 9a, 9d), and
- assembling the connectors (9, 9a, 9b, 9c, 9d) together by fitting the male (93) and female (97) parts of the connectors (9, 9a, 9b, 9c, 9d) of adjacent pairs of plates (3, 3').
